# EUROPEAN PATENT APPLICATION

(11) **EP 4 844 418 A1**
(43) Date of publication of application: **25.11.2026**
(21) Application number: 24918801.2
(22) Date of filing: 16.01.2024
(51) Int. Cl.: G01R 31/12

(54) **PARTIAL DISCHARGE DETERMINING DEVICE**

(71) Applicant: Mitsubishi Electric Corporation, Tokyo 100-8310 (JP)
(72) Inventor: SAKATA, Yuma, Tokyo 100-8310 (JP); NAKAUCHI, Shinichiro, Tokyo 100-8310 (JP)
(74) Representative: Witte, Weller & Partner Patentanwälte mbB
(86) International application number: PCT/JP2024/000883
(87) International publication number: WO 2025/154153

(57) **Abstract**

A partial discharge determination device (100) includes: a first insulating spacer (10) including a first member (11) and a second member (12), the first member (11) being an insulating member, the second member (12) being a conductive member covering a side surface of the first member and reducing an influence of an electromagnetic wave from outside, the first insulating spacer being sandwiched between and connected to the first tank (21) and the second tank (22); a first antenna (14) that is provided inside the first member and detects an electromagnetic wave generated from the first tank and/or the second tank; a second antenna (15) that is provided inside the first member, is provided closer to the second tank than the first antenna, and detects an electromagnetic wave generated from the first tank and/or the second tank; and a control unit (40) that determines, from a first electromagnetic wave and a second electromagnetic wave, whether a partial discharge has occurred inside the first tank or inside the second tank, the first electromagnetic wave being an electromagnetic wave detected by the first antenna, the second electromagnetic wave being an electromagnetic wave detected by the second antenna.

## Description

### Field

The present disclosure relates to a partial discharge determination device.

### Background

Conventionally, there is a partial discharge determination device for partial discharge generated inside a gas insulation device. As in the partial discharge detection device described in Patent Literature 1, the insulating spacer is covered with a metal cover, a plurality of slot-shaped openings (antenna units for detecting electromagnetic waves) provided in the metal cover are provided, and electromagnetic waves accompanying the occurrence of partial discharge are detected by the plurality of slot-shaped openings (antenna units for detecting electromagnetic waves). As a result, partial discharge can be detected with a simple configuration.

### Citation List

### Patent Literature

Patent Literature 1: Japanese Patent Application Laid-open No. 2007-263640

### Summary of Invention

### Problem to be solved by the Invention

However, in the conventional partial discharge detection device described above, since the metal cover is disposed on the outer periphery of the gas insulation device, the slot-shaped opening that detects electromagnetic waves is also disposed on the outer periphery of the gas insulation device. For this reason, not only the electromagnetic waves due to the partial discharge generated inside the gas insulation device but also the disturbance such as broadcast waves and wireless communication waves arriving from the outside of the gas insulation device are detected. Therefore, there is a possibility that the partial discharge detection device disclosed in Patent Literature 1 cannot accurately detect the partial discharge in the gas insulation device due to disturbance.

The present disclosure has been made to solve the above-described problems, and an object thereof is to provide a partial discharge determination device capable of reducing the influence of disturbance and determining partial discharge generated in a gas insulation device with higher accuracy.

### Means to Solve the Problem

A partial discharge determination device according to the present disclosure comprises: a first insulating spacer including a first member and a second member, the first member being an insulating member, the second member being a conductive member covering a side surface of the first member and reducing an influence of an electromagnetic wave from outside, the first insulating spacer being sandwiched between and connected to a first tank and a second tank; a first antenna that is provided inside the first member and detects an electromagnetic wave generated from the first tank and/or the second tank; a second antenna that is provided inside the first member, is provided closer to the second tank than the first antenna, and detects an electromagnetic wave generated from the first tank and/or the second tank; and a control unit to determine, from a first electromagnetic wave and a second electromagnetic wave, whether a partial discharge has occurred inside the first tank or inside the second tank, the first electromagnetic wave being an electromagnetic wave detected by the first antenna, the second electromagnetic wave being an electromagnetic wave detected by the second antenna.

### Effects of the Invention

In the partial discharge determination device of the present disclosure, a plurality of antennas that detect an electromagnetic wave are provided inside a first member that is an insulating member, and the first member is covered with a second member that is a conductive member. Consequently, the conductive member reduces the detection of disturbance by the antennas, so that the partial discharge can be determined with high accuracy.

### Brief Description of Drawings

FIG. 1 is a cross-sectional view of a partial discharge determination device according to the first embodiment.
FIG. 2(a) is a plan view of the insulating spacer constituting the partial discharge determination device according to the first embodiment.
FIG. 2(b) is a cross-sectional view of the insulating spacer constituting the partial discharge determination device according to the first embodiment.
FIG. 3 is a diagram for explaining a waveform of a normal electromagnetic wave and a waveform of an abnormal electromagnetic wave.
FIG. 4 is a processing flow of partial discharge determination according to the first embodiment.
FIG. 5 is a processing flow of partial discharge determination according to the second embodiment.
FIG. 6(a) is a plan view of the insulating spacer constituting the partial discharge determination device according to the third embodiment.
FIG. 6(b) is a cross-sectional view of the insulating spacer constituting the partial discharge determination device according to the third embodiment.
FIG. 7(a) is a plan view of the insulating spacer constituting the partial discharge determination device according to the fourth embodiment.
FIG. 7(b) is an enlarged view of each cross section of the insulating spacer constituting the partial discharge determination device according to the fourth embodiment.
FIG. 8 is a cross-sectional view of a partial discharge determination device according to the fifth embodiment.

### Description of Embodiments

### First Embodiment.

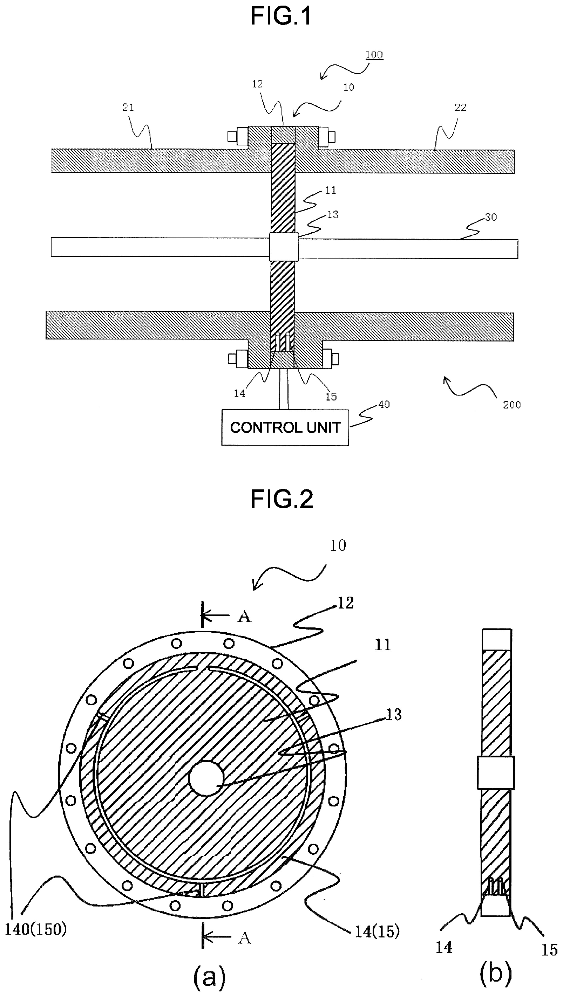

A partial discharge determination device according to the first embodiment will be described with reference to FIGS. 1 to 4. FIG. 1 is a cross-sectional view of a partial discharge determination device according to the first embodiment. The partial discharge determination device 100 includes an insulating spacer 10 and a control unit 40. The insulating spacer 10, a first tank 21, a second tank 22, and a conductor 30 constitute a part of the gas insulation device 200. The insulating spacer 10 is also referred to as a first insulating spacer.

The first tank 21 and the second tank 22 are connected to the insulating spacer 10. The first tank 21 and the second tank 22 are fixed by bolts so as to sandwich the insulating spacer 10.

The insulating spacer 10 includes a first member 11 that is an insulating member, a second member 12 that is a conductive member covering an outer peripheral side surface of the first member 11, and a conductor holding portion 13. Inside the first member, a first antenna 14 and a second antenna 15 provided closer to the second tank than the first antenna are provided. The first antenna 14 and the second antenna 15 detect an electromagnetic wave generated from the inside of the first tank 21 or the inside of the second tank 22. The first antenna 14 and the second antenna 15 are made of a conductive member such as aluminum. The first antenna 14 and the second antenna 15 are connected to the control unit 40. The first antenna 14 transmits a first electromagnetic wave, which is the electromagnetic wave detected by the first antenna 14, to the control unit 40. The second antenna 15 transmits a second electromagnetic wave, which is the electromagnetic wave detected by the second antenna 15, to the control unit 40. The control unit 40 determines whether a partial discharge has occurred inside the first tank 21 or inside the second tank 22 from the first electromagnetic wave and the second electromagnetic wave acquired from the first antenna 14 and the second antenna 15. The conductor holding portion 13 holds the conductor 30 through which high-voltage electricity flows. The conductor holding portion 13 is made of a conductive member. Here, the inside of the first tank 21 or the inside of the second tank 22 is not limited to the internal space of the first tank 21 or the second tank 22, and also indicates the internal surface of the first tank 21 or the second tank 22, the conductor 30 disposed inside, and the like.

Next, a structure of the insulating spacer according to the first embodiment will be described. FIG. 2(a) is a plan view of the insulating spacer constituting the partial discharge determination device according to the first embodiment, and FIG. 2(b) is a cross-sectional view of the insulating spacer constituting the partial discharge determination device according to the first embodiment, and is a cross-sectional view taken along line A-A of FIG. 2(a). The insulating spacer 10 includes the first member 11 inside and has a disk shape. The second member 12 has a hollow disk shape and is provided so as to cover the first member 11. The first antenna 14 and the second antenna 15 are provided inside the first member 11. Since the second member 12 is made of a conductive member, the second member 12 reduces detection of disturbance such as broadcast waves and wireless communication waves by the first antenna 14 and the second antenna 15 inside. The conductor holding portion 13 is located substantially at the center of the insulating spacer.

In addition, a first root 140 that is the root of the first antenna 14 and a second root 150 that is the root of the second antenna 15 are connected to the second member 12. The second member 12 has a hole for passing a cable for connection with the control unit 40 (not illustrated). The first antenna 14 and the second antenna 15 are connected to the control unit 40 through the cable. The first antenna 14 and the second antenna 15 are the same components.

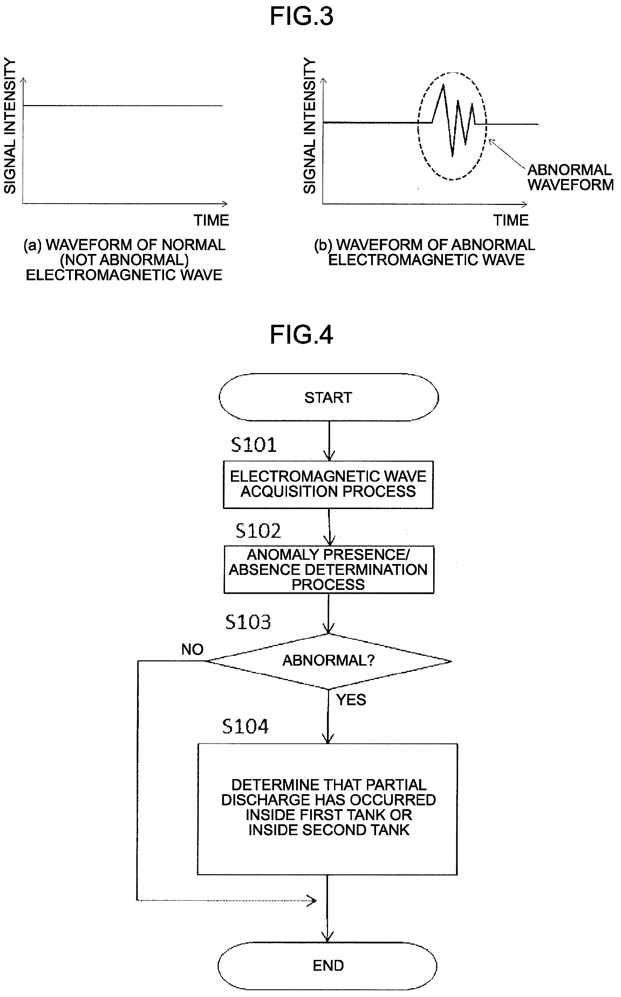

Next, a method in which the control unit 40 determines that there is no anomaly or there is anomaly in the first electromagnetic wave and the second electromagnetic wave will be described. FIG. 3 is a diagram for explaining a waveform of a normal (not abnormal) electromagnetic wave and a waveform of an abnormal electromagnetic wave. FIG. 3(a) is a waveform of a normal (not abnormal) electromagnetic wave, and FIG. 3(b) is a waveform diagram of an abnormal electromagnetic wave. In both drawings, the horizontal axis represents time, the vertical axis represents signal intensity, and the waveform represents a change in signal intensity with time change. The waveform 4 of the normal (not abnormal) electromagnetic wave shows substantially constant signal intensity regardless of the lapse of time as illustrated in FIG. 3(a). On the other hand, as the abnormal waveform, a rapid change in signal intensity occurs as in a region surrounded by a dotted line in FIG. 3(b). From the waveforms of the first electromagnetic wave and the second electromagnetic wave, the control unit 40 determines whether a sudden change in signal intensity has occurred, and determines the presence or absence of anomaly, whether abnormal or normal (not abnormal).

Next, a process in which the control unit 40 of the partial discharge determination device 100 determines whether a partial discharge has occurred inside the first tank 21 or inside the second tank 22 will be described. FIG. 4 is a processing flow of partial discharge determination performed by the control unit 40 according to the first embodiment.

The control unit 40 performs a process of acquiring the first electromagnetic wave and the second electromagnetic wave (step S101). Next, the control unit 40 determines the presence or absence of anomaly, whether the first electromagnetic wave and the second electromagnetic wave acquired in the same time zone in step S101 are abnormal or normal (not abnormal) (step S102). Next, from the result of the presence or absence of anomaly determined in step S102, if there is an anomaly in the first electromagnetic wave and the second electromagnetic wave (step S103: YES), the control unit 40 determines the presence or absence of a partial discharge inside the first tank 21 or inside the second tank 22 (step S104). On the other hand, if either the first electromagnetic wave or the second electromagnetic wave is normal (not abnormal) in the process of step S103 (step S103: NO), there is no partial discharge, and the process is ended.

As described above, in the partial discharge determination device 100, the first antenna 14 and the second antenna 15 that detect the electromagnetic wave generated from the inside of the first tank 21 or the inside of the second tank 22 are provided in the first member 11 that is an insulating member, and the periphery is covered with the second member 12 that is a conductive member. Accordingly, the second member 12 reduces detection of disturbance such as broadcast waves and wireless communication waves by the first antenna 14 and the second antenna 15. Consequently, the control unit 40 can accurately determine whether a partial discharge has occurred in the gas insulation device based on the electromagnetic waves detected by the first antenna 14 and the second antenna 15 less influenced by the disturbance.

In addition, by using the same components for the first antenna 14 and the second antenna 15, an effect of reducing cost can also be obtained.

When only one of the first electromagnetic wave and the second electromagnetic wave is determined to be abnormal in the determination process of step S103, it is not determined that a partial discharge has occurred in the gas insulation device, but it may be determined that the sensor is simply abnormal.

### Second Embodiment.

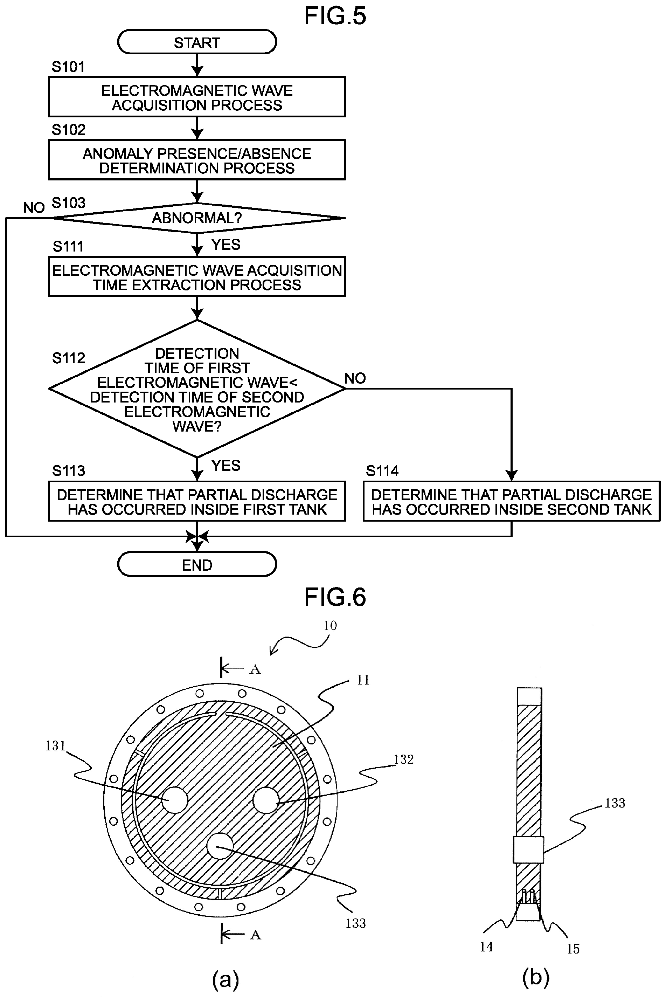

The partial discharge determination device 100 in the second embodiment will be described with reference to FIG. 5. In FIG. 5, the same reference signs as those in FIG. 4 denote the same or corresponding parts. While the partial discharge determination device of the first embodiment determines whether a partial discharge has occurred in the first tank 21 or the second tank 22, the partial discharge determination device of the second embodiment is configured to determine inside which tank a partial discharge has occurred, inside the first tank 21 or inside the second tank.

FIG. 5 is a processing flow of partial discharge determination performed by the control unit 40 according to the second embodiment. In the process of step S103, if there is an anomaly in the first electromagnetic wave and the second electromagnetic wave (step S103: YES), the control unit 40 acquires a first time when the first antenna 14 detects the anomaly of the first electromagnetic wave and a second time when the second antenna 15 detects the anomaly of the second electromagnetic wave (step S111). That is, for each of the first electromagnetic wave and the second electromagnetic wave, the first time and the second time, which are the times when the abnormal waveform referred to in FIG. 3(b) is detected, are acquired. The time when the abnormal waveform is detected may be a time when the abnormal waveform starts, a time when the peak value of the abnormal waveform is detected, an intermediate time when the abnormal waveform occurs, or any other time while the abnormal waveform occurs.

Next, the control unit 40 compares the first time and the second time (step S112). If the first time is earlier than the second time (step S112: YES), a partial discharge is determined to have occurred inside the first tank 21 closer to the first antenna 14 than the second tank 22 (step S113). On the other hand, if the second time is on or after the second time in the process of step S112 (step S113: NO), a partial discharge is determined to have occurred inside the second tank 22 closer to the second antenna 15 than the first tank 21 (step S114).

As described above, the partial discharge determination device 100 according to the second embodiment determines inside which tank a partial discharge has occurred, inside the first tank 21 or inside the second tank 22, from the first time at which the first antenna 14 detects the anomaly of the first electromagnetic wave and the second time at which the second antenna 15 detects the anomaly of the second electromagnetic wave. As a result, the tank to be maintained is identified, and the efficiency of the maintenance work is also improved.

Note that the criterion for determination is not limited to the time, and for example, it may be determined inside which tank a partial discharge has occurred, inside the first tank 21 or inside the second tank 22, by comparing the peak values of the abnormal waveform. In this case, it is determined that a partial discharge has occurred inside the tank close to the antenna that has detected the electromagnetic wave having the larger peak value. For example, if the peak value of the first electromagnetic wave is larger than the peak value of the second electromagnetic wave, a partial discharge is determined to have occurred inside the first tank 21 close to the first antenna 14 that has detected the first electromagnetic wave. On the other hand, if the peak value of the second electromagnetic wave is larger than the peak value of the first electromagnetic wave, a partial discharge is determined to have occurred inside the second tank 22 close to the second antenna 15 that has detected the second electromagnetic wave.

### Third Embodiment.

The partial discharge determination device 100 in the third embodiment will be described with reference to FIG. 6. In FIG. 6, the same reference signs as those in FIG. 2 denote the same or corresponding parts. While the insulating spacer in the partial discharge determination device of the first embodiment includes one conductor holding portion, the insulating spacer in the partial discharge determination device of the third embodiment is configured to include a plurality of conductor holding portions.

FIG. 6(a) is a plan view of the insulating spacer constituting the partial discharge determination device according to the third embodiment, and FIG. 6(b) is a cross-sectional view of the insulating spacer constituting the partial discharge determination device according to the third embodiment, and is a cross-sectional view taken along line A-A of FIG. 6(a). The insulating spacer 10 according to the third embodiment includes a first conductor holding portion 131, a second conductor holding portion 132, a third conductor holding portion 133, and three conductor holding portions. These conductor holding portions hold the conductors 30, but the phases of the currents of the respective conductors are different.

As described above, in the partial discharge determination device 100 according to the third embodiment, one insulating spacer 10 holds a plurality of conductors having different phases of currents. As a result, it is not necessary to prepare the insulating spacer 10 for each phase, so that the number of components can be reduced, and the cost of the entire gas insulation device can be lowered.

### Fourth Embodiment.

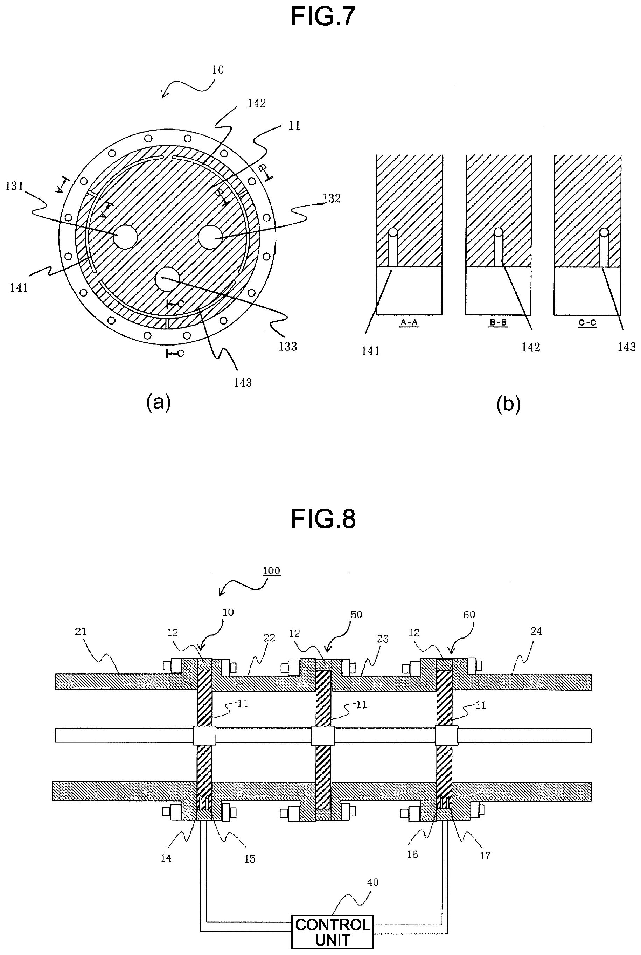

The partial discharge determination device 100 in the fourth embodiment will be described with reference to FIG. 7. In FIG. 7, the same reference signs as those in FIG. 6 denote the same or corresponding parts. While the partial discharge determination devices according to the first and third embodiments determine whether a partial discharge has occurred inside the first tank or inside the second tank, the partial discharge determination device according to the fourth embodiment determines in which conductor a partial discharge has occurred in the circumferential direction when a plurality of conductors are held as in the third embodiment.

FIG. 7(a) is a plan view of the insulating spacer constituting the partial discharge determination device according to the fourth embodiment, and FIG. 7(b) is an enlarged view of each cross section of the insulating spacer constituting the partial discharge determination device according to the fourth embodiment. As illustrated in FIG. 7(a), the plurality of antennas 141, 142, and 143 are provided at different positions in the circumferential direction of the insulating spacer. In addition, the first antenna 141 is provided at a position closer to the first conductor holding portion 131 than the second conductor holding portion 132 and the third conductor holding portion 133, the second antenna 142 is provided at a position closer to the second conductor holding portion 132 than the first conductor holding portion 131 and the third conductor holding portion 133, and the third antenna 143 is provided at a position closer to the third conductor holding portion 133 than the first conductor holding portion 131 and the second conductor holding portion 132.

FIG. 7(b) is an enlarged view of each cross section illustrated in FIG. 7(a), and the plurality of antennas 141, 142, and 143 are disposed at different positions in the conductor axial direction. As described above, when a partial discharge occurs in the conductor held by any one of the conductor holding portions 131 to 133, it can be determined in which conductor holding portion the partial discharge has occurred. For example, a method of determining that there is an anomaly, that is, a partial discharge has occurred, in the conductor held by the conductor holding portion close to the antenna that has detected the electromagnetic wave having the highest peak value of the abnormal waveform, is conceivable. In this case, an abnormal waveform is detected in each of the first antenna 141, the second antenna 142, and the third antenna 143, and when the peak value of the electromagnetic wave of first antenna 141 is the highest, it is determined that anomaly, that is, partial discharge, has occurred in the conductor held by the first conductor holding portion 131 close to the first antenna 141. On the other hand, when the peak value of the electromagnetic wave of the second antenna 142 is the highest, it is determined that anomaly, that is, partial discharge, has occurred in the conductor held by the second conductor holding portion 132 close to the second antenna 142. On the other hand, when the peak value of the electromagnetic wave of the third antenna 143 is the highest, it is determined that anomaly, that is, partial discharge, has occurred in the conductor held by the third conductor holding portion 133 close to the third antenna 143.

As described above, the partial discharge determination device 100 according to the fourth embodiment disposes the plurality of antennas at different positions in the circumferential direction of the insulating spacer, and disposes the plurality of antennas at positions close to different conductors. As a result, it is possible to determine in which conductor the anomaly, that is, the partial discharge, has occurred.

In the fourth embodiment, for the sake of convenience, the case where the number of conductors is three, the number of antennas is three, and the number of conductors and the number of antennas are the same has been described, but the present disclosure is not limited thereto, and the number of conductors and the number of antennas may be different. For example, in FIG. 7, when there is no second antenna 142 near the second conductor holding portion 132, even when a partial discharge occurs in the conductor held by the second conductor holding portion 132, if peak values of abnormal waveforms detected by the first antenna 141 and the third antenna 143 are the same, it can be determined that a partial discharge has occurred in the conductor held by the second conductor holding portion 132 at substantially the same distance as the first antenna 141 and the third antenna 143.

### Fifth Embodiment.

The partial discharge determination device 100 in the fifth embodiment will be described with reference to FIG. 8. In FIG. 8, the same reference signs as those in FIG. 1 denote the same or corresponding parts. In the partial discharge determination device of the first embodiment, one insulating spacer is connected to the first tank and the second tank sandwiching the insulating spacer, whereas in the partial discharge determination device of the fifth embodiment, a plurality of insulating spacers and tanks are further connected.

FIG. 8 is a cross-sectional view of a partial discharge determination device according to the fifth embodiment. When the insulating spacer 10 in the first embodiment is referred to as the first insulating spacer 10, the partial discharge determination device 100 according to the fifth embodiment includes a third insulating spacer 60 in addition to the first insulating spacer 10 and the control unit 40. In the gas insulation device 200 according to the fifth embodiment, the second tank 22 is connected to a second insulating spacer 50 apart from the first insulating spacer 10. Further, there is a third tank 23 connected to the second insulating spacer 50. The third tank 23 and the second tank 22 sandwich the second insulating spacer 50 therebetween. Further, apart from the second insulating spacer 50, there is a third insulating spacer 60 connected to the third tank 23. Further, there is a fourth tank 24 connected to the third insulating spacer 60. The fourth tank 24 and the third tank 23 sandwich the third insulating spacer 60 therebetween. In this case, both the second insulating spacer 50 and the third insulating spacer 6 include the first member 11 that is an insulating member, the second member 12 that is a conductive member covering the outer peripheral side surface of the first member 11, and the conductor holding portion 13.

Inside the first member 11 of the third insulating spacer 60, a fourth antenna 16 and a fifth antenna 17 are provided. The fourth antenna 16 and the fifth antenna 17 detect an electromagnetic wave generated from the inside of the third tank 23 or the inside of the fourth tank 24. The fourth antenna 16 and the fifth antenna 17 are made of a conductive member such as aluminum. The fourth antenna 16 and the fifth antenna 17 are connected to the control unit 40. The fourth antenna 16 transmits a fourth electromagnetic wave, which is the electromagnetic wave detected by the fourth antenna 16, to the control unit 40. The fifth antenna 17 transmits a fifth electromagnetic wave, which is the electromagnetic wave detected by the fifth antenna 17, to the control unit 40. The control unit 40 determines, from the fourth electromagnetic wave and the fifth electromagnetic wave acquired from the fourth antenna 16 and the fifth antenna 17, whether a partial discharge has occurred inside the third tank 23 or inside the fourth tank 24. Here, the inside of the third tank 23 or the inside of the fourth tank 24 is not limited to the internal space of the third tank 23 or the fourth tank 24, and also indicates the internal surface of the third tank 23 or the fourth tank 24, the conductor 30 disposed inside, and the like. On the other hand, the second insulating spacer 50 does not have an antenna.

Similarly to first insulating spacer 10, the fourth antenna 16 and the fifth antenna 17 are connected to the control unit 40. By the fourth electromagnetic wave that is the electromagnetic wave detected by the fourth antenna 16 included in the third insulating spacer 60 and the fifth electromagnetic wave that is the electromagnetic wave detected by the fifth antenna 17, the control unit 40 determines whether a partial discharge has occurred inside the third tank 23 connected to the third insulating spacer or inside the fourth tank 24.

As described above, the partial discharge determination device 100 according to the fifth embodiment determines, based on the electromagnetic waves detected by the first antenna 14 and the second antenna 15, whether a partial discharge has occurred inside the first tank 21 or inside the second tank 22. The partial discharge determination device 100 of the fifth embodiment determines, based on the electromagnetic waves detected by the fourth antenna 16 and the fifth antenna 17, whether a partial discharge has occurred inside the third tank 23 or inside the fourth tank 24. Accordingly, even when the second insulating spacer 50 does not have an antenna, it is possible to determine whether a partial discharge has occurred inside the first tank 21 to the fourth tank 24. Therefore, it is not necessary to provide an antenna on the second insulating spacer 50, so that the number of components can be reduced, and the cost of the entire gas insulation device can be lowered.

### Reference Signs List

10 insulating spacer (first insulating spacer); 11 first member; 12 second member; 13 conductor holding portion; 14, 141 first antenna; 15, 142 second antenna; 16 fourth antenna; 17 fifth antenna; 21 first tank; 22 second tank; 23 third tank; 34 fourth tank; 30 conductor; 40 control unit; 50 second insulating spacer; 60 third insulating spacer; 100 partial discharge determination device; 131 first conductor holding portion; 132 second conductor holding portion; 133 third conductor holding portion; 143 third antenna.

## Claims

1. A partial discharge determination device comprising:
a first insulating spacer including a first member and a second member, the first member being an insulating member, the second member being a conductive member covering a side surface of the first member and reducing an influence of an electromagnetic wave from outside, the first insulating spacer being sandwiched between and connected to a first tank and a second tank;
a first antenna that is provided inside the first member and detects an electromagnetic wave generated from the first tank and/or the second tank;
a second antenna that is provided inside the first member, is provided closer to the second tank than the first antenna, and detects an electromagnetic wave generated from the first tank and/or the second tank; and
a control unit to determine, from a first electromagnetic wave and a second electromagnetic wave, whether a partial discharge has occurred inside the first tank or inside the second tank, the first electromagnetic wave being an electromagnetic wave detected by the first antenna, the second electromagnetic wave being an electromagnetic wave detected by the second antenna.

2. The partial discharge determination device according to claim 1, wherein
the control unit
determines, from waveforms of the first electromagnetic wave and the second electromagnetic wave, presence or absence of anomaly in electromagnetic wave, and
determines that a partial discharge has occurred inside the first tank when a first time at which anomaly of the first electromagnetic wave determined to be abnormal is detected is earlier than a second time at which anomaly of the second electromagnetic wave determined to be abnormal is detected, and determines that a partial discharge has occurred in the second tank when the first time is later than the second time.

3. The partial discharge determination device according to claim 1 or 2, wherein the first antenna and the second antenna have identical shapes.

4. The partial discharge determination device according to any one of claims 1 to 3, wherein
the first insulating spacer holds a plurality of conductors having different phases of currents, and
the plurality of conductors are located inside the first tank or inside the second tank.

5. The partial discharge determination device according to claim 4, wherein
the first antenna is provided at a position different from the second antenna in a circumferential direction of the first insulating spacer, and
the control unit determines, from the first electromagnetic wave and the second electromagnetic wave, in which of the plurality of conductors a partial discharge has occurred.

6. The partial discharge determination device according to claim 5, further comprising:
a third antenna that is provided at a position different from the first antenna and the second antenna in the circumferential direction of the first insulating spacer, and detects an electromagnetic wave generated from the first tank and/or the second tank; and
a first conductor holding portion, a second conductor holding portion, and a third conductor holding portion that are provided in the first member and each hold a corresponding one of the conductors, wherein
the first antenna is disposed at a position closer to the first conductor holding portion than the second conductor holding portion and the third conductor holding portion,
the second antenna is disposed at a position closer to the second conductor holding portion than the first conductor holding portion and the third conductor holding portion,
the third antenna is disposed at a position closer to the third conductor holding portion than the first conductor holding portion and the second conductor holding portion,
the control unit determines, from the first electromagnetic wave, the second electromagnetic wave, and a third electromagnetic wave, in which of the conductor held by the first conductor holding portion, the conductor held by the second conductor holding portion, or the conductor held by the third conductor holding portion a partial discharge has occurred, the third electromagnetic wave being an electromagnetic wave detected by the third antenna.

7. The partial discharge determination device according to any one of claims 1 to 6, further comprising:
a third insulating spacer sandwiched between and connected to a third tank and a fourth tank, the third tank and the second tank sandwiching a second insulating spacer therebetween, the third tank being connected to the second insulating spacer, the second insulating spacer including the first member and the second member covering a side surface of the first member, the third insulating spacer including the first member and the second member covering a side surface of the first member;
a fourth antenna that is provided inside the first member of the third insulating spacer and detects an electromagnetic wave generated from inside the third tank and/or inside the fourth tank; and
a fifth antenna that is provided inside the first member of the third insulating spacer, is provided closer to the fourth tank than the fourth antenna, and detects an electromagnetic wave generated from inside the third tank and/or inside the fourth tank, wherein
the control unit
determines, from a first electromagnetic wave and a second electromagnetic wave, whether a partial discharge has occurred inside the first tank or inside the second tank, the first electromagnetic wave being an electromagnetic wave detected by the first antenna, the second electromagnetic wave being an electromagnetic wave detected by the second antenna, and
determines, from a fourth electromagnetic wave and a fifth electromagnetic wave, whether a partial discharge has occurred inside the third tank or inside the fourth tank, the fourth electromagnetic wave being an electromagnetic wave detected by the fourth antenna, the fifth electromagnetic wave being an electromagnetic wave detected by the fifth antenna.
